# EUROPEAN PATENT APPLICATION

(11) **EP 4 682 888 A1**
(43) Date of publication of application: **21.01.2026**
(21) Application number: 25188769.1
(22) Date of filing: 10.07.2025
(51) Int. Cl.: G11C 29/44, G11C 29/38, G11C 29/42

(54) **MEMORY BUILT-IN-SELF-TEST (MBIST) WITH ENHANCED FAULT INDICATORS**

(30) Priority: 16.07.2024 IN 202441054283
(71) Applicant: NXP USA, Inc., Austin, TX 78735 (US)
(72) Inventor: He, Chen, 5656AG Eindhoven (NL); Spruth, Henning Fritz, 5656AG Eindhoven (NL); Qureshi, Qadeer, 5656AG Eindhoven (NL); Nautiyal, Hemant, 5656AG Eindhoven (NL); Poudel, Rohan, 5656AG Eindhoven (NL)
(74) Representative: Miles, John Richard

(57) **Abstract**

A memory built-in self-test (BIST) controller, corresponding to a partition BIST controller, is configured to control memory testing in one or more corresponding static random access memories (RAMs) and has a first corresponding register configured to store a failure indicator for each of the one or more corresponding RAMs and a second corresponding register configured to store an uncorrectable failure indicator for each of the one or more corresponding RAMs. The partition BIST controller is configured to generate, based on the first and second registers of the MBIST controller, a first in-field test status indicator which indicates whether a failure occurred during memory testing of any RAM corresponding to the partition BIST controller and a second in-field test status indicator which indicates whether an uncorrectable failure occurred during the memory testing of any RAM corresponding to the partition BIST controller.

## Description

### BACKGROUND

### Field

This disclosure relates generally to memories, and more specifically, to memory built-in-self-test (MBIST) with enhanced fault indicators.

### Related Art

Current MBIST control units do not provide sufficient diagnostic visibility when memory fails are detected during in-field testing. This can result in false or unnecessary customer returns or inaccurate parts-per-million (ppm) failure risk when MBIST fails due to single bit errors which can be corrected by Error Correcting Code (ECC) during in-field operation. The problem becomes more prevalent in that ppm risk further increases as features decrease in size. Therefore, a need exists for improved fault indication by MBIST control units.

### BRIEF DESCRIPTION OF THE DRAWINGS

The present invention is illustrated by way of example and is not limited by the accompanying figures, in which like references indicate similar elements. Elements in the figures are illustrated for simplicity and clarity and have not necessarily been drawn to scale.
FIG. 1 illustrates, in block diagram form, a system-on-a-chip (SoC) having random access memories (RAMs), memory built-in-self-test (MBIST) controllers, partition build-in-self-test (BIST) controllers (PBCs), and local self test control units (LSTCU), and a central self test control unit (CSTCU), in accordance with an embodiment of the present invention.
FIG. 2 illustrates, in partial flow diagram and partial block diagram form, an MBIST controller and a PBC useable in the SoC of FIG. 1, in accordance with an embodiment of the present invention.
FIG. 3 illustrates, in block diagram form, an interface between the PBC of FIG. 2 and an LSTCU, in accordance with an embodiment of the present invention.
FIG. 4 illustrates, in table form, descriptions for set of in-field test status indicators (ift_status), in accordance with an embodiment of the present invention.
FIG. 5 illustrates, in block diagram form, a more detailed view of the LSTCU of FIG. 3, in accordance with an embodiment of the present invention.

### DETAILED DESCRIPTION

As indicated above, current MBIST control units do not provide sufficient diagnostic visibility during in-field testing. Therefore, in one aspect, an MBIST controller is capable of providing enhanced diagnostic information with respect to memory failures during memory testing, such as an indication whether a memory failure is caused by single bit errors or multiple bit errors. A partition BIST controller (PBC) can receive this failure information from a set of MBIST controllers and, in response, generate a set of in-field test status indicators (ift_status[1:0]) which provide information with respect to both RAM single bit errors (which may therefore be correctable by error correcting code (ECC) during in-field operation) and RAM multiple bit errors (which are not correctable by the ECC). This information can be provided to a local self test control unit (STCU) or to a central STCU (or both) which stores the indicators. The indicators can be stored, for example, without any software interaction and without the risk of losing information due to a functional reset at the end of any self tests controlled by the STCUs. For example, the status information can be stored in non-volatile memory or registers which can retain values after functional reset of an STCU.

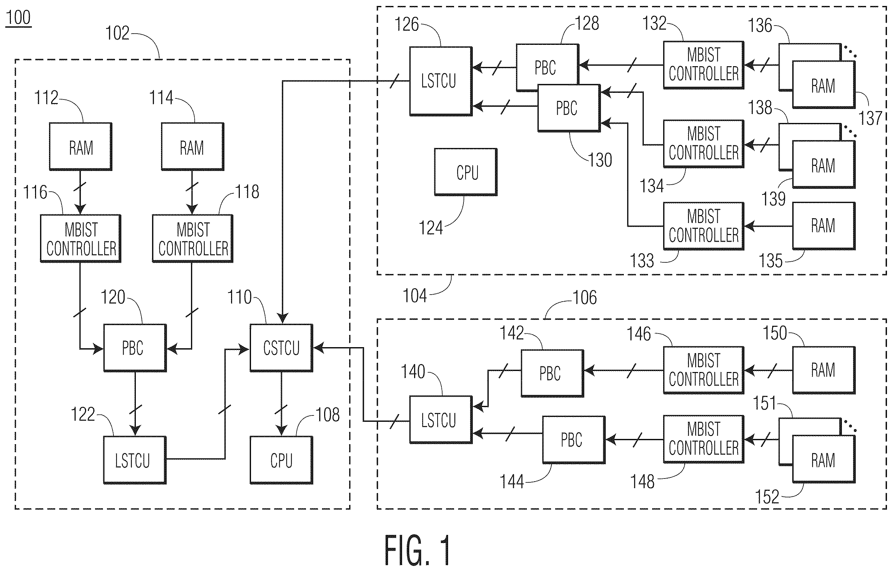

FIG. 1 illustrates, in block diagram form, an SoC 100, in accordance with an embodiment of the present invention, in which SoC 100 includes subsystems 102, 104, and 106. Each subsystem may include any number of memories (e.g. RAMs), MBIST controllers (i.e. MBIST control units), and PBCs, and include an LSTCU. Each subsystem may also include other elements, as needed, to implement the desired functionality of the subsystem. For example, subsystem 102 also includes a central processing unit (CPU) 108, and subsystem 104 includes a CPU 124. In alternate embodiments, a subsystem can include any type of processing unit (e.g. CPUs, graphical processing unit (GPU), image processing unit, etc.) and may include any other type of circuitry, peripheral, input/output module, etc. In the illustrated embodiment, one of the subsystems (e.g. subsystem 102) includes a CSTCU 110 which is coupled to receive information from the LSTCUs (e.g. LSTCU 122 of subsystem 102, LSTCU 126 of subsystem 104, and LSTCU 140 of subsystem 106). Although FIG. 1 illustrates three subsystems, SoC 100 may include any number (one or more) of subsystems, in which each subsystem includes a corresponding LSTCU. In the case that there is only one subsystem, there may be only one STCU (rather than both a local and central STCU).

Each subsystem includes one or more PBCs configured to provide information to the LSTCU of the subsystem, in which each PBC receives information from one or more MBIST controllers. Each MBIST controller operates to control memory testing in a corresponding one or more memories (which may be implemented as RAMs, and may therefore be referred to as RAMs). For example, subsystem 102 includes PBC 120 coupled to LSTCU 122 and coupled to each of MBIST controllers 116 and 118. MBIST controller 116 is coupled to RAM 112, and MBIST controller 118 is coupled to RAM 114. In this subsystem, each MBIST controller is configured to control memory testing in a corresponding RAM. Subsystem 104 includes PBCs 128 and 130, each coupled to LSTCU 126, in which PBC 118 is coupled to MBIST controller 132, and PBC 130 is coupled to MBIST controller 134 and MBIST controller 133. MBIST controller 132 is coupled to a plurality of RAMS 136-137 and controls memory testing in each of these RAMS, MBIST controller 134 is coupled to a plurality of RAMS 138-139 and controls memory testing in each of these RAMs, and MBIST controller 133 is coupled to RAM 135 and controls testing in this RAM. Subsystem 106 includes PBCs 142 and 144, each coupled to LSTCU 140, in which PBC 142 is coupled to MBIS controller 146, and PBC 144 is coupled to MBIST controller 148. MBIST controller 146 is coupled to an RAM 150 and controls memory testing in RAM 150, and MBIST controller 148 is coupled to a plurality of RAMS 151-152 and controls memory testing in each of these RAMS. Subsystem 102 includes CSTCU 110 which is coupled to each of LSTCU 122, LSTCU 126, and LSTCU 140.

Note that each illustrated RAM of the subsystems corresponds to a particular PBC. For example, RAMs 112 and 114 both correspond to PBC 120, RAMs 136-137 corresponds to PBC 128, RAMs 138-139 and 135 correspond to PBC 130, RAM 150 corresponds to PBC 142 and RAMs 151-152 corresponds to PBC 144. Also, as used herein, an MBIST controller controls or tests a corresponding RAM by controlling memory testing in the corresponding RAM. For example, RAMs 136-137 can be described as being controlled or tested by MBIST controller 132 since MBIST controller 132 controls memory testing in each of these RAMs. Note that each RAM also includes a corresponding memory array, read/write circuitry, control circuitry, etc., as needed and as known in the art, to perform writes to and reads from the corresponding memory array.

In operation, an MBIST controller controls memory operations for memory testing in one or more RAMs coupled to the MBIST controller. This may include performing writes of test data to the one or more RAMs, reads from the one or more RAMs, and comparing the read data to the expected previously written test data. Note that the MBIST controllers can be implemented using any type of known MBIST circuitry to perform any type of known MBIST testing with any type of test patterns. Typically, though, MBIST controllers (and STCUs) do not include ECC logic to perform ECC detection and correction, as adding ECC affects the timing for every MBIST pattern of reads and writes, which adds unnecessary test time. Further, it may not be feasible to implement ECC in the case of third party RAM compilers. Therefore, without the presence of ECC logic, the MBIST controllers do not typically provide visibility of single bit or multiple bit errors when MBIST fails. Therefore, in one embodiment, each MBIST controller includes a set of registers in which a first register, referred to as a failure per memory (FPM) register, is configured to store a bit (i.e. failure indicator) for each RAM controlled by the MBIST controller to indicate whether or not the memory had a failure during the memory testing, and a second register, referred to as a multi-bit fail detection (EFD) register, is configured to store a bit (i.e. uncorrectable failure indicator) for each RAM controlled by the MBIST controller to indicate whether or not the memory had a multi-bit failure (or uncorrectable failure) during the memory testing. Note that the FPM and EFD registers can be implemented with any type of storage circuitry.

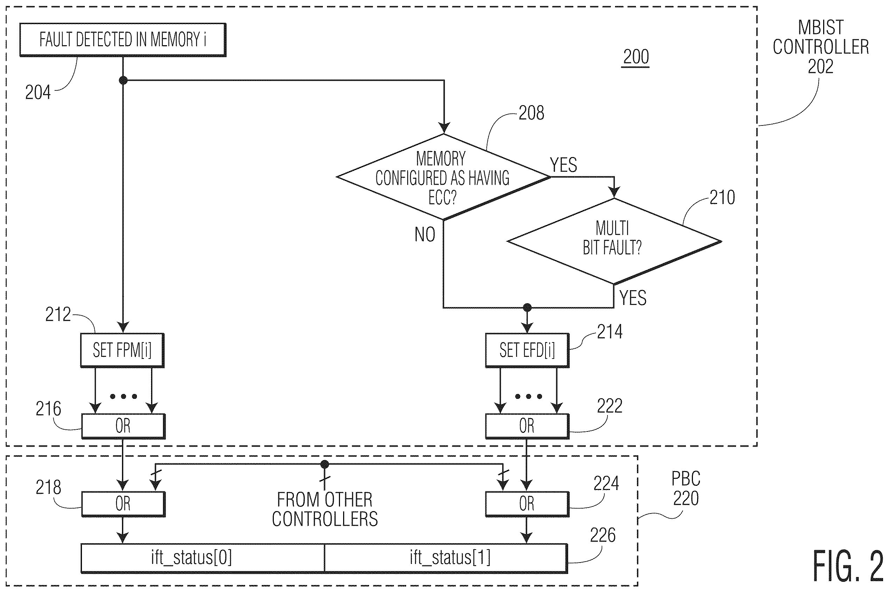

FIG. 2 illustrates, in partial flow diagram and partial block diagram form, a more detailed view of a PBC 220 and a corresponding MBIST controller 202, in accordance with one embodiment of the present invention. PBC 220 can be any PBC within SoC 100, and MBIST controller 202 can be any MBIST controller corresponding to and coupled to the PBC within SoC 100. However, for the descriptions herein of FIG. 2, it will be assumed that MBIST controller 202 and PBC 220 describe MBIST controller 132 and PBC 128 of subsystem 104. Therefore, references to MBIST controller 202 and PBC 220 are equivalent to referencing MBIST controller 132 and PBC 128 of FIG. 1. As illustrated in FIG. 1, MBIST controller 132 corresponds to the plurality of RAMs 136-137. In one embodiment, the plurality of RAMs includes 8 RAMs, in which each can be identified with an index value of 0-7 such that a first RAM of the plurality is RAM[0], a second RAM of the plurality is RAM[1], a third RAM is RAM[2], and so on, until RAM[7].

Referring to MBIST controller 202 of FIG. 2, MBIST controller 202 includes a Failure per Memory (FPM) register 212 and an ECC Fail Detection (EFD) register 214. Each register includes a plurality of bits in which each bit corresponds to a RAM instance controlled by the MBIST controller. For example, in the illustrated embodiment of FIG. 2, each FPM and EFD register includes 8 bits (FPM[0:7] and EFD[0:7]), one bit corresponding to each of RAM[0] - RAM[7] of RAMs 136-137, in which each bit in each register corresponds to one of the 8 RAMs to provide information with respect to that RAM. Operation of MBIST controller 202 with respect to these registers is described in reference to method 200, in which method 200 begins with block 204 in which a first memory (memory i) is selected and tested, in which a fault (e.g. error) is detected as a result of the testing. For example, memory i may refer to any one of RAM[0] - RAM[7] of RAMS 136-137. Since a fault is detected in memory i, the corresponding i-th bit of FPM register 212 (FPM[i]) is set to one. In one embodiment, prior to any testing by MBIST controller 132, each of FPM and EFD is cleared to zero, such that if no error is found in an RAM, then the corresponding bit of FPM remains cleared to zero.

Once a fault is detected in memory i in block 204, method 200 proceeds to decision diamond 208 in which it is determined whether memory i (the corresponding RAM) is configured as having ECC (i.e. is configured with ECC enabled). If not, then it does not matter whether the fault is a single-bit error or multi-bit error, as ECC is not available for correcting any error, and therefore, the i-th bit of EFD (EFD[i]) is set to one to indicate the uncorrectable error. If the corresponding RAM does have ECC, at decision diamond 210, only if it is a multi-bit error does the EFD[i] get set to one, otherwise EFD[i] remains zero. That is, if the corresponding RAM does have ECC, any single bit error is correctable by the ECC during in-field operations and therefore, there is no need to indicate an uncorrectable error. Therefore, each bit of FPM, when asserted, indicates that the corresponding RAM has an error, and each of bit of EFD, when asserted, indicates that the corresponding RAM has an uncorrectable error (e.g. a multi-bit error not correctable by ECC or a single-bit error in the case that ECC is not available).

The ORed values of the FPM and EFD registers are provided to PBC 220 which generates, based on these register values, ift_status[0] and ift_status[1], in which each of these status bits can be stored in storage circuitry 226 (e.g. a register). OR circuit 222 of MBIST controller 202 performs a logical OR of the bit values in EFD 214, and provides the one bit result to OR circuit 224 of PBC 220. In one embodiment, OR circuit 224 of PBC 220 receives results from other MBIST controllers and ORs them together to provide the final one bit ORed result as ift _status[1]. For example, if PBC 128 were coupled to multiple MBIST controllers (such as PBC 120 which is coupled to both MBIST controllers 116 and 118), then the results of the corresponding OR circuit similar to OR circuit 222 of each MBIST controller is provided to OR circuit 224 to generate ift_status[1]. In the case of only one MBIST controller, the result of OR circuit 222 may be provided directly as ift _status[1]. Similarly, OR circuit 216 of MBIST controller 202 performs a logical OR of the bit values in FPM 212, and provides the one bit result to OR circuit 218 of PBC 220. In one embodiment, OR circuit 218 receives results from other MBIST controllers and ORs them together to provide the final one bit ORed results as ift_status[0].

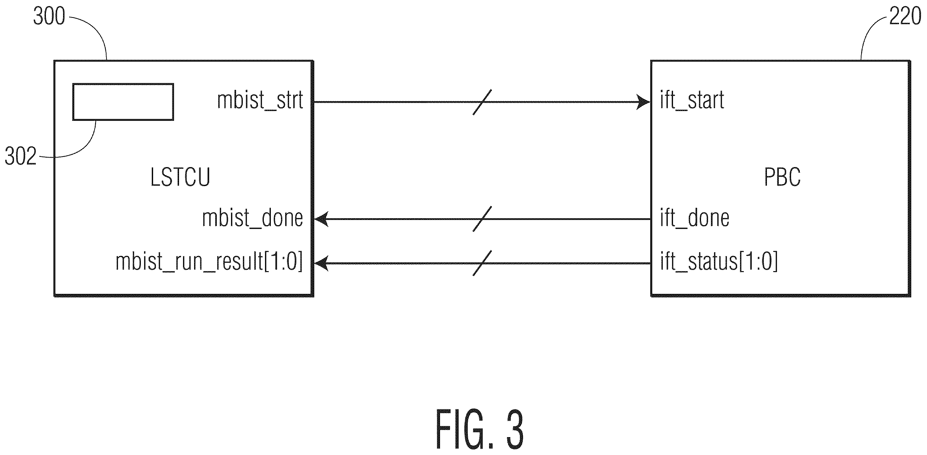

FIG. 3 illustrates, in block diagram form, an interface between LSTCU 300 and PBC 220, in which, for the descriptions herein, it is assumed that LSTCU 300 corresponds to LSTCU 126 of subsystem 104 of FIG. 1. In the illustrated embodiment, LSTCU 300, which is configured to control all the self testing of subsystem 104, provides an MBIST start indicator (mbist_strt) to PBC 220 which receives the indicator as in-field testing start (ift_start). In response to assertion of ift_start, PBC 220 instructs each corresponding MBIST controller (e.g. MBIST controller 132) to start its memory testing on the corresponding RAMs (RAMs 136-137). When all of the corresponding MBIST controllers have completed their testing, PBC 220 asserts ift_done. When LSTCU 300 receives the asserted ift_done as MBIST_done, LSTCU 300 also receives the MBIST test results (MBIST_run_result[1:0]). These MBIST test results correspond to ift _status[1:0] provided by PBC 220 to LSTCU 300 as a result of MBIST controller 132 performing the memory testing. These MBIST test results (e.g. the values of ift_status[1:0]) can be stored in a non-volatile storage circuit 302 (e.g. a non-volatile memory) of LSTCU 300.

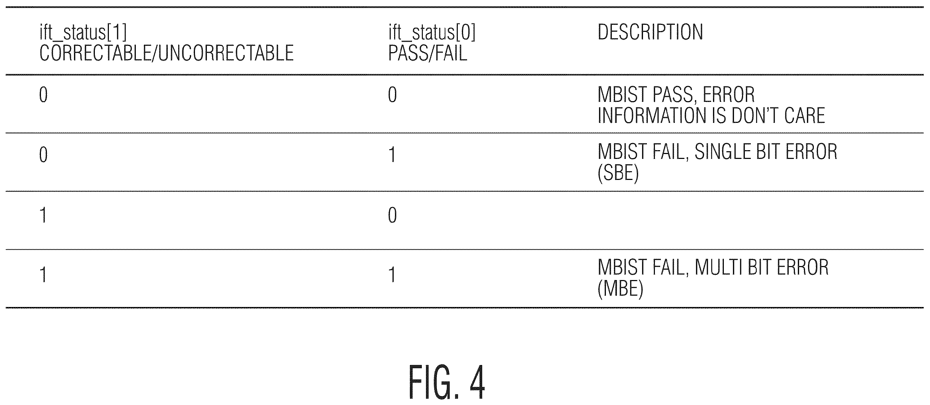

FIG. 4 provides, in table form, summarized descriptions of each bit in ift_status[1:0], as provided by PBC 220, in accordance with an embodiment of the present invention. Ift_status[0] is a simple pass/fail indicator, based on the values in the FPM registers, which simply indicates whether the MBIST memory testing of the RAMs corresponding to PBC 220 results in an error or not, and ift _status[1], which is based on values of the EFD registers, further indicates whether any error in the RAMs corresponding to PBC 220 is correctable or uncorrectable. Therefore, in the case that ift_status[0] is negated to 0, no error is indicated. That is, no error or fault occurred during the memory testing performed by the MBIST controllers corresponding to PBC 220. In this case, state of ift_status[1] is a "don't care" or is simply not applicable (N/A) because no error or fault was determined. However, if ift_status[0] is asserted to one, meaning an error or fault did occur during the memory testing, ift_status[1] provides further diagnostic information regarding the fault. If ift_status[1] is negated to a zero, the error (e.g. the "MBIST fail") is indicated as a single bit error (SBE) and the corresponding RAM is configured with ECC enabled during functional operation meaning that the SBE is correctable and therefore not an "uncorrectable error." If ift_status[0] is asserted to a one, though, the error (e.g. the "MBIST fail") is indicated as a multi-bit error (MBE) and therefore is a true error (i.e. one that is not correctable). Note that ift _status[0] being asserted to one can also mean that the error is an SBE but that the corresponding RAM is not configured with ECC enabled and therefore, even the SBE is not correctable. Therefore, the additional diagnostic information provided by ift _status[1] can be used to further characterized errors and further determine subsequent actions, based on a customer's implementation of the SoC.

Note that, in alternate embodiments, each RAM may be configured to include different types of ECC. In the examples above, it is assumed that if the RAM is configured to include ECC, the RAM implements a multi-bit error detection and single-bit error correction ECC algorithm. Therefore, in this case, a multi-bit error corresponds to an uncorrectable error. However, in other examples, the RAM can be configured to use more complex ECC algorithms, as known in the art, such as a triple-bit error detection and a double-bit error correction. These require more processing time and more complex logic, but in this example, the ift_status[1] can be set to one if a triple-bit error is detected rather than just a multi-bit error, since a double-bit error would be correctable but a triple-bit error would not be. Therefore, the ift_status[1] bit used to indicate that an error found in the corresponding RAM is uncorrectable due to the absence of ECC to correct any errors, or because the available ECC algorithm is not sufficient to correct the found errors (e.g. based on the number of bit errors detected).

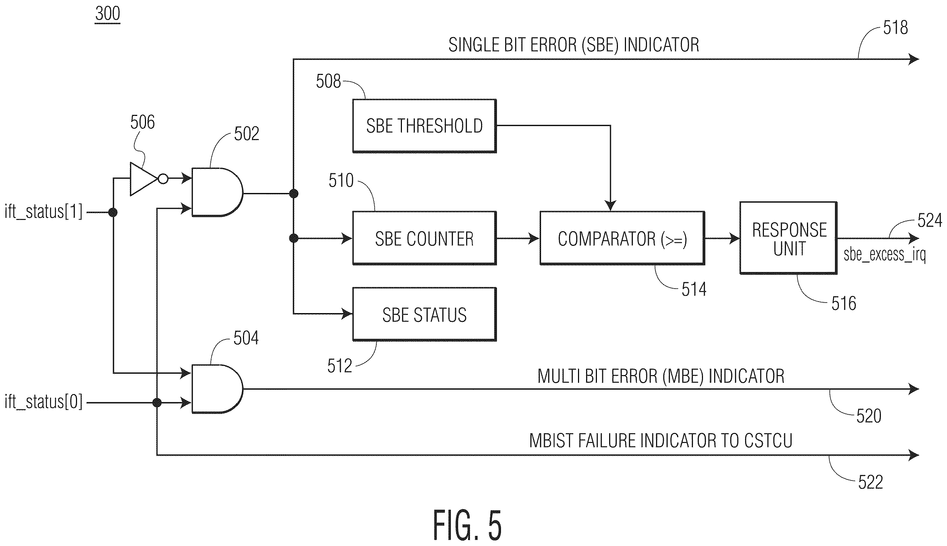

FIG. 5 illustrates, in block diagram form, an embodiment of LSTCU 300 of FIG. 3, in accordance with one embodiment of the present invention. LSTCU 300 receives ift _status[1:0] from PBC 220, and provides various output indicators, such as an SBE indicator 518 (which, when asserted to a one, indicates occurrence of an SBE), an MBE indicator 520 (which, when asserted to a one, indicates occurrence of an MBE), and an MBIST failure indicator 522 (which, when asserted to a one, indicates occurrence of an MBIST failure either due to an SBE or MBE). LSTCU 300 includes inverter 506, AND gates 502 and 504, an SBE threshold resister 508, an SBE counter 510, a comparison circuit 514 (also referred to as a comparator), an SBE status register 512, and a response unit 516. An input of inverter 506 is coupled to receive ift_status[1] and an output of inverter 506 is coupled to a first input of AND gate 502. A second input of AND gate 502 is coupled to receive ift_status[0]. A first input of AND gate 504 is coupled to receive ift_status[1], and a second input of AND gate 504 is coupled to receive ift_status[0]. An output of AND gate 502 is coupled to an input of SBE counter 510 and an input of SBE status register 512. An output of AND gate 504 provides MBE indicator 520. MBIST failure indicator 522 is directly coupled to ift_status[0] such that ift _status[0] is provided as MBIST failure indictor 522.

The output of AND gate 502 is asserted each time both ift_status[0] is 1 (indicating an MBIST failure occurred) and ift_status[1] is 0 (indicating that the MBIST failure is due to an SBE and is thus correctable). SBE counter 510 counts each assertion of the output of AND gate 502. Thus SBE counter 510 counts how many times a correctable error is found in an RAM of the corresponding subsystem. As the number of SBEs increases, this may mean that the health of the RAMs of SoC 100 is deteriorating. Comparison circuit 514 is configured to compare the count value of SBE counter 510 to an SBE thresholds stored in SBE threshold 508. An output of comparison circuit 514 is provided to response unit 516 and indicates whether or not the count value has exceeded the SBE threshold. Response unit 516, based on customer requirements, can take appropriate action based on the comparison result. For example, in one embodiment, in response to the SBE count value exceeding the SBE threshold, response unit 516 may assert a hardware interrupt 524 (e.g. sbe_excess_irq) to CPU 124 to indicate that an excessive number of SBEs has occurred. This can be used by CPU 124, or other interrupt handler of SoC 100 or by CSTCU 110 to provide more information towards an application which manages the device health. MBE indicator 520 is simply provided as the ANDing of ift _status[1] and ift _status[0], which, when asserted, indicates an uncorrectable MBE error. Note that SBE counter 510 and comparison circuit 514 can be implemented with any known logic circuitry, and in alternate embodiments, different logic in place of or in addition to AND gates 502 and 504 and inverter 506 may be used to receive ift_status[1:0] and generate the appropriate indicators.

Note that the circuitry of FIG. 5 can be implemented in a first PBC channel (e.g. a channel 0) of the subsystem (e.g. from PBC 128 as PBC channel 0 in subsystem 104), and that the circuitry of FIG. 5 can be repeated or instantiated for each PBC channel of a multichannel implementation (e.g. for PBC 130 as PBC channel 1 in subsystem 104). In this example, response unit 516 may receive outputs of the comparison logic (e.g. comparison logic 514) of each PBC channel to determine the response. For example, the hardware interrupt can be asserted if any of the PBC channels indicates that a corresponding SBE count threshold has been exceeded. Similarly, the MBE indicator from each PBC channel can be combined so as to assert a single MBE indicator (such as an MBE interrupt) if any of the MBEs of any of the PBC channels is asserted. The same can be done for the MBIST failure indicators from each PBC channel.

Note that the information provided by the ift_status indicators can be stored by the LSTCU of each subsystem without the need for any software intervention to explicitly store the results of the memory testing. In one embodiment, the ift_status indicators are evaluated (such as by the corresponding LSTCU to determine, e.g., SBE counts) with each MBIST run, in which an MBIST run may include the testing of a set of RAMs as controlled by the corresponding MBIST controllers. Note that software can read the SBE counters, as needed, and clear them prior to each MBIST run. Also, if the ift_status indicators and count values of the SBE counters are stored in non-volatile memory (e.g. 302) of each LSTCU, the information is not lost upon functional resets between MBIST runs.

Therefore, by now it can be appreciated how status indicators with improved diagnostic information can be generated and stored, in accordance with various embodiments o the present invention. These indicators may be generated by each partition MBIST controller, covering the RAMs corresponding to the PBC. In one embodiment, a first indicator indicates whether memory testing of any of the RAMs corresponding to the PBC resulted in an error, while a second indicator further indicates whether any error is uncorrectable or not. In this manner, improved information can be obtained after in-field MBIST testing of the RAMs of an SoC.

The terms "assert" or "set" and "negate" (or "deassert" or "clear") are used herein when referring to the rendering of a signal, status bit, or similar apparatus into its logically true or logically false state, respectively. If the logically true state is a logic level one, the logically false state is a logic level zero. And if the logically true state is a logic level zero, the logically false state is a logic level one.

Each signal described herein may be designed as positive or negative logic, where negative logic can be indicated by a bar over the signal name or an asterisk (*) following the name. In the case of a negative logic signal, the signal is active low where the logically true state corresponds to a logic level zero. In the case of a positive logic signal, the signal is active high where the logically true state corresponds to a logic level one. Note that any of the signals described herein can be designed as either negative or positive logic signals. Therefore, in alternate embodiments, those signals described as positive logic signals may be implemented as negative logic signals, and those signals described as negative logic signals may be implemented as positive logic signals.

Brackets are used herein to indicate the conductors of a bus or the bit locations of a value. For example, "value[7:0]" or "value[0:7]" indicates eight bit values of the value. The symbol "$" preceding a number indicates that the number is represented in its hexadecimal or base sixteen form. The symbol "%" preceding a number indicates that the number is represented in its binary or base two form.

Because the apparatus implementing the present invention is, for the most part, composed of electronic components and circuits known to those skilled in the art, circuit details will not be explained in any greater extent than that considered necessary as illustrated above, for the understanding and appreciation of the underlying concepts of the present invention and in order not to obfuscate or distract from the teachings of the present invention.

Although the invention has been described with respect to specific conductivity types or polarity of potentials, skilled artisans appreciated that conductivity types and polarities of potentials may be reversed.

Moreover, the terms "front," "back," "top," "bottom," "over," "under" and the like in the description and in the claims, if any, are used for descriptive purposes and not necessarily for describing permanent relative positions. It is understood that the terms so used are interchangeable under appropriate circumstances such that the embodiments of the invention described herein are, for example, capable of operation in other orientations than those illustrated or otherwise described herein.

Some of the above embodiments, as applicable, may be implemented using a variety of different information processing systems. For example, although FIG. 1 and the discussion thereof describe an exemplary information processing architecture, this exemplary architecture is presented merely to provide a useful reference in discussing various aspects of the invention. Of course, the description of the architecture has been simplified for purposes of discussion, and it is just one of many different types of appropriate architectures that may be used in accordance with the invention. Those skilled in the art will recognize that the boundaries between logic blocks are merely illustrative and that alternative embodiments may merge logic blocks or circuit elements or impose an alternate decomposition of functionality upon various logic blocks or circuit elements. Thus, it is to be understood that the architectures depicted herein are merely exemplary, and that in fact many other architectures can be implemented which achieve the same functionality.

Also for example, in one embodiment, the illustrated elements of system 100 are circuitry located on a single integrated circuit or within a same device (such as an SoC). Alternatively, system 100 may include any number of separate integrated circuits or separate devices interconnected with each other.

A memory built-in self-test (BIST) controller, corresponding to a partition BIST controller, is configured to control memory testing in one or more corresponding static random access memories (RAMs) and has a first corresponding register configured to store a failure indicator for each of the one or more corresponding RAMs and a second corresponding register configured to store an uncorrectable failure indicator for each of the one or more corresponding RAMs. The partition BIST controller is configured to generate, based on the first and second registers of the MBIST controller, a first in-field test status indicator which indicates whether a failure occurred during memory testing of any RAM corresponding to the partition BIST controller and a second in-field test status indicator which indicates whether an uncorrectable failure occurred during the memory testing of any RAM corresponding to the partition BIST controller.

Furthermore, those skilled in the art will recognize that boundaries between the functionality of the above described operations merely illustrative. The functionality of multiple operations may be combined into a single operation, and/or the functionality of a single operation may be distributed in additional operations. Moreover, alternative embodiments may include multiple instances of a particular operation, and the order of operations may be altered in various other embodiments.

Although the invention is described herein with reference to specific embodiments, various modifications and changes can be made without departing from the scope of the present invention as set forth in the claims below. For example, a PBC can correspond to any number of MBIST controllers, and therefore, to any number of RAMs which are controlled and tested by the MBIST controllers. Accordingly, the specification and figures are to be regarded in an illustrative rather than a restrictive sense, and all such modifications are intended to be included within the scope of the present invention. Any benefits, advantages, or solutions to problems that are described herein with regard to specific embodiments are not intended to be construed as a critical, required, or essential feature or element of any or all the claims.

The term "coupled," as used herein, is not intended to be limited to a direct coupling or a mechanical coupling.

Furthermore, the terms "a" or "an," as used herein, are defined as one or more than one. Also, the use of introductory phrases such as "at least one" and "one or more" in the claims should not be construed to imply that the introduction of another claim element by the indefinite articles "a" or "an" limits any particular claim containing such introduced claim element to inventions containing only one such element, even when the same claim includes the introductory phrases "one or more" or "at least one" and indefinite articles such as "a" or "an." The same holds true for the use of definite articles.

Unless stated otherwise, terms such as "first" and "second" are used to arbitrarily distinguish between the elements such terms describe. Thus, these terms are not necessarily intended to indicate temporal or other prioritization of such elements.

The following are various embodiments of the present invention. Note that any of the aspects below can be used in any combination with each other and with any of the disclosed embodiments.

In an embodiment, an integrated circuit includes a partition built-in-self-test (BIST) controller; and a memory BIST (MBIST) controller corresponding to the partition BIST controller, the MBIST controller configured to control memory testing in one or more corresponding static random access memories (RAMs), the MBIST controller having a first corresponding register configured to store a failure indicator for each of the one or more corresponding RAMs and a second corresponding register configured to store an uncorrectable failure indicator for each of the one or more corresponding RAMs. In the embodiment, the partition BIST controller is configured to generate, based on the first and second registers of the MBIST controller corresponding to the partition BIST controller, a first in-field test status indicator which indicates whether a failure occurred during memory testing of any RAM corresponding to the partition BIST controller and a second in-field test status indicator which indicates whether an uncorrectable failure occurred during the memory testing of any RAM corresponding to the partition BIST controller. In one aspect of the embodiment, the integrated circuit further includes a second MBIST controller corresponding to the partition BIST controller, the second MBIST controller configured to control memory testing in one or more corresponding static random access memories (RAMs), the second MBIST controller having a first corresponding register configured to store a failure indicator for each of the one or more corresponding RAMs tested by the second MBIST controller and a second corresponding register configured to store an uncorrectable failure indicator for each of the one or more corresponding RAMs tested by the second MBIST controller. In a further aspect, the partition BIST controller is configured to generate the second in-field test status indicator based on the second registers of the MBIST controller and the second MBIST controller. In yet a further aspect, the partition BIST controller is configured to generate a single bit as the second in-field test status indicator based on a logical ORing of the uncorrectable failure indicators of each of the second registers. In another yet further aspect, the partition BIST controller is configured to generate the first in-field test status indicator based on the first registers of the MBIST controller and the second MBIST controller. In yet a further aspect, the integrated circuit further includes a local self test control unit (LSTCU) configured to receive the first and second in-field test status indicators from the partition BIST controller, the LSTCU including a counter configured to count single bit errors based on the first and second in-field test status indicators; and a non-volatile storage circuit configured to store the first and second in-field test status indicators and a count value of the counter. In another aspect of the embodiment, the integrated circuit further includes a local self test control unit (LSTCU) coupled to receive the first and second in-field test status indicators from the partition BIST controller, the LSTCU includes a counter configured to count single bit errors based on the first and second in-field test status indicators; a non-volatile storage circuit configured to store the first and second in-field test status indicators and a count value of the counter; and a comparison circuit configured to compare the count value with a predetermined single bit error threshold. In yet a further aspect, the integrated circuit further includes a second partition BIST controller is configured to generate a first in-field test status indicator which indicates whether a failure occurred during memory testing of any RAM corresponding to the second partition BIST controller and a second in-field test status indicator which indicates whether an uncorrectable failure occurred during the memory testing of any RAM corresponding to the second partition BIST controller, wherein the LSTCU is coupled to receive the first and second in-field test status indicators from the second partition BIST controller. In another further aspect, the integrated circuit includes a plurality of subsystems, wherein a first subsystem includes the partition BIST controller, the MBIST controller, the one or more RAMs controlled by the MBIST controller, and the LSTCU, and a second subsystem includes a second partition built-in-self-test (BIST) controller; a second memory BIST (MBIST) controller corresponding to the second partition BIST controller, the second MBIST controller configured to control memory testing in one or more corresponding static random access memories (RAMs), the second MBIST controller having a first corresponding register configured to store a failure indicator for each of the one or more corresponding RAMs tested by the second MBIST controller and a second corresponding register configured to store an uncorrectable failure indicator for each of the one or more corresponding RAMs tested by the second MBIST controller. In this further aspect, the second partition BIST controller is configured to generate, based on the first and second registers of the second MBIST controller corresponding to the second partition BIST controller, a first in-field test status indicator which indicates whether a failure occurred during memory testing of any RAM corresponding to the second partition BIST controller and a second in-field test status indicator which indicates whether an uncorrectable failure occurred during the memory testing of any RAM corresponding to the second partition BIST controller. In this further aspect, the second subsystem further includes a second LSTCU coupled to receive the first and second in-field test status indicators from the second partition BIST controller; and a central self test control unit (CSTCU) coupled to receive and store the first and second in-field test status indicators from the partition BIST controller of the first subsystem and from the second partition BIST controller. In yet a further aspect, the first subsystem does not include any CSTCU. In another aspect of the above embodiment, the MBIST controller is configured to control memory testing in each of the one or more corresponding RAMs by controlling test writes to the corresponding RAM and test reads from the corresponding RAM. In yet another aspect, the MBIST controller is configured to, in response to detecting a fault in a first corresponding RAM, assert an uncorrectable failure indicator in the second register for the first corresponding RAM when the first corresponding RAM is configured as having ECC and the fault is determined to be a multi-bit error. In a further aspect, the MBIST controller is configured to, in response to detecting the fault in the first corresponding RAM, assert the uncorrectable failure indicator in the second register for the first corresponding RAM when the first corresponding RAM is configured as not having ECC. In another further aspect, the MBIST controller is configured to, in response to detecting the fault in the first corresponding RAM, assert a failure indicator in the first register for the first corresponding RAM. In yet another further aspect, each of the one or more RAMs corresponding to the MBIST controller has a corresponding bit in the second register to provide a corresponding uncorrectable failure indicator. In yet an even further aspect, each of the one or more RAMs corresponding to the MBIST controller has a corresponding bit in the first register to provide a corresponding failure indicator.

In another embodiment, an integrated circuit includes a plurality of subsystems, each subsystem includes a corresponding local self test control unit (LSTCU) and a set of partition built-in self test (BIST) controllers coupled to the corresponding LSTCU, each configured to provide a corresponding set of in-field test status indicators to the corresponding LSTCU; wherein each partition BIST controller in the plurality of subsystems is coupled to a corresponding set of MBIST controllers, each configured to control memory testing in each of a corresponding set of RAMs, and, in response to memory testing the corresponding set of RAMs, store both a failure indicator and an uncorrectable failure indicator for each RAM of the corresponding set of RAMs, wherein the failure indicator indicates whether a failure occurred during the memory testing and the uncorrectable failure indicator indicates whether an uncorrectable failure occurred during the memory testing. In this another embodiment, each partition BIST controller in the plurality of subsystems is configured to receive the stored failure indicators and uncorrectable failure indicators and generate, for the RAMs corresponding to the set of MBIST controllers coupled to the partition BIST controller, a first in-field test status indicator of the corresponding set of in-field test status indicators which indicates whether a failure occurred during memory testing of any RAM corresponding to the partition BIST controller, and a second in-field test status indicator of the corresponding set of in-field test status indicators which indicates whether an uncorrectable failure occurred during the memory testing of any RAM corresponding to the partition BIST controller. In one aspect of the another embodiment, only one of the plurality of subsystems includes a central self test control unit (CSTCU) coupled to receive and store the corresponding sets of in-field test status indicators from the partition BIST controllers of the plurality of subsystems. In another aspect, each MBIST controller of the plurality of subsystems is configured to, in response to detecting a fault in a first corresponding RAM of the set of corresponding RAMs during the memory testing, assert the uncorrectable failure indicator for the first corresponding RAM when either the first corresponding RAM is configured as having ECC and the fault is determined to be a multi-bit error, or the first corresponding RAM is configured as not having ECC. In a further aspect, the MBIST controller is configured to, in response to detecting the fault in the first corresponding RAM during the memory testing, assert the failure indicator for the first corresponding RAM.

## Claims

1. An integrated circuit, comprising:
a partition built-in-self-test (BIST) controller; and
a memory BIST (MBIST) controller corresponding to the partition BIST controller, the MBIST controller configured to control memory testing in one or more corresponding static random access memories (RAMs), the MBIST controller having a first corresponding register configured to store a failure indicator for each of the one or more corresponding RAMs and a second corresponding register configured to store an uncorrectable failure indicator for each of the one or more corresponding RAMs,
wherein the partition BIST controller is configured to generate, based on the first and second registers of the MBIST controller corresponding to the partition BIST controller, a first in-field test status indicator which indicates whether a failure occurred during memory testing of any RAM corresponding to the partition BIST controller and a second in-field test status indicator which indicates whether an uncorrectable failure occurred during the memory testing of any RAM corresponding to the partition BIST controller.

2. The integrated circuit of claim 1, further comprising:
a second MBIST controller corresponding to the partition BIST controller, the second MBIST controller configured to control memory testing in one or more corresponding static random access memories (RAMs), the second MBIST controller having a first corresponding register configured to store a failure indicator for each of the one or more corresponding RAMs tested by the second MBIST controller and a second corresponding register configured to store an uncorrectable failure indicator for each of the one or more corresponding RAMs tested by the second MBIST controller.

3. The integrated circuit of claim 2, wherein the partition BIST controller is configured to generate the second in-field test status indicator based on the second registers of the MBIST controller and the second MBIST controller.

4. The integrated circuit of claim 3, wherein the partition BIST controller is configured to generate a single bit as the second in-field test status indicator based on a logical ORing of the uncorrectable failure indicators of each of the second registers.

5. The integrated circuit of claim 3 or 4, wherein the partition BIST controller is configured to generate the first in-field test status indicator based on the first registers of the MBIST controller and the second MBIST controller.

6. The integrated circuit of any preceding claim , further comprising:
a local self test control unit (LSTCU) configured to receive the first and second in-field test status indicators from the partition BIST controller, the LSTCU comprising:
a counter configured to count single bit errors based on the first and second in-field test status indicators; and
a non-volatile storage circuit configured to store the first and second in-field test status indicators and a count value of the counter.

7. The integrated circuit of claim 6, further comprising:
a comparison circuit configured to compare the count value with a predetermined single bit error threshold.

8. The integrated circuit of claim 6 or 7, further comprising:
a second partition BIST controller is configured to generate a first in-field test status indicator which indicates whether a failure occurred during memory testing of any RAM corresponding to the second partition BIST controller and a second in-field test status indicator which indicates whether an uncorrectable failure occurred during the memory testing of any RAM corresponding to the second partition BIST controller,
wherein the LSTCU is coupled to receive the first and second in-field test status indicators from the second partition BIST controller.

9. The integrated circuit of any of claims 6 to 8 comprising a plurality of subsystems, wherein a first subsystem includes the partition BIST controller, the MBIST controller, the one or more RAMs controlled by the MBIST controller, and the LSTCU, and a second subsystem includes:
a second partition built-in-self-test (BIST) controller;
a second memory BIST (MBIST) controller corresponding to the second partition BIST controller, the second MBIST controller configured to control memory testing in one or more corresponding static random access memories (RAMs), the second MBIST controller having a first corresponding register configured to store a failure indicator for each of the one or more corresponding RAMs tested by the second MBIST controller and a second corresponding register configured to store an uncorrectable failure indicator for each of the one or more corresponding RAMs tested by the second MBIST controller,
wherein the second partition BIST controller is configured to generate, based on the first and second registers of the second MBIST controller corresponding to the second partition BIST controller, a first in-field test status indicator which indicates whether a failure occurred during memory testing of any RAM corresponding to the second partition BIST controller and a second in-field test status indicator which indicates whether an uncorrectable failure occurred during the memory testing of any RAM corresponding to the second partition BIST controller;
a second LSTCU coupled to receive the first and second in-field test status indicators from the second partition BIST controller; and
a central self test control unit (CSTCU) coupled to receive and store the first and second in-field test status indicators from the partition BIST controller of the first subsystem and from the second partition BIST controller.

10. The integrated circuit of claim 9, wherein the first subsystem does not include any CSTCU.

11. The integrated circuit of any preceding claim, wherein the MBIST controller is configured to control memory testing in each of the one or more corresponding RAMs by controlling test writes to the corresponding RAM and test reads from the corresponding RAM.

12. The integrated circuit of any preceding claim, wherein the MBIST controller is configured to, in response to detecting a fault in a first corresponding RAM, assert an uncorrectable failure indicator in the second register for the first corresponding RAM when the first corresponding RAM is configured as having ECC and the fault is determined to be a multi-bit error.

13. The integrated circuit of claim 12, wherein the MBIST controller is configured to, in response to detecting the fault in the first corresponding RAM, assert the uncorrectable failure indicator in the second register for the first corresponding RAM when the first corresponding RAM is configured as not having ECC.

14. The integrated circuit of claim 12 or 13, wherein the MBIST controller is configured to, in response to detecting the fault in the first corresponding RAM, assert a failure indicator in the first register for the first corresponding RAM.

15. The integrated circuit of any of claims 12 to 14, wherein each of the one or more RAMs corresponding to the MBIST controller has a corresponding bit in the second register to provide a corresponding uncorrectable failure indicator.
